# FASCICULE DE BREVET EUROPEEN

(11) **EP 1 792 528 B1**
(45) Date de publication et mention de la délivrance du brevet: **16.07.2014**
(21) Numéro de dépôt: 05802474.6
(22) Date de dépôt: 13.09.2005
(51) Int. Cl.: G06K 19/077, H01L 23/66, H05K 3/32, G07D 7/00, H01L 23/00, H01L 23/13

(54) **PROCEDE DE MONTAGE D'UN COMPOSANT ELECTRONIQUE SUR UN SUPPORT, DE PREFERENCE MOU, ET ENTITE ELECTRONIQUE AINSI OBTENUE, TELLE QU'UN PASSEPORT**
VERFAHREN ZUR ANBRINGUNG EINER ELEKTRONISCHEN KOMPONENTE AUF EINEN VORZUGSWEISE WEICHEN TRÄGER UND DARAUS RESULTIERENDE ELEKTRONISCHE EINHEIT, WIE Z. B. EIN PASS
METHOD FOR MOUNTING AN ELECTRONIC COMPONENT ON A PREFERABLY SOFT SUPPORT, AND RESULTING ELECTRONIC ENITITY, SUCH AS A PASSPORT

(30) Priorité: 24.09.2004 FR 0410146
(43) Date de publication de la demande: 06.06.2007
(73) Titulaire: OBERTHUR CARD SYSTEMS SA, 75017 Paris (FR); François Charles Oberthur Fiduciaire, 75017 Paris (FR)
(72) Inventeur: ENOUF, Guy, F-14190 Saint-Sylvain (FR); BORDE, Xavier, F-35410 Osse (FR); DEMAIMAY, Florian, F-35000 Rennes (FR)
(74) Mandataire: Quantin, Bruno Marie Henri
(86) Numéro de dépôt international: PCT/FR2005/002266
(87) Numéro de publication internationale: WO 2006/035128

(56) Documents cités:
- EP-A- 1 167 068
- FR-A- 2 779 255
- US-A- 5 928 458
- US-B1- 6 281 048

## Description

L'invention concerne la réalisation d'une connexion électrique entre une puce électronique et son support, par exemple un support mou, tel que celui d'un passeport à puce intégrée.

On a déjà proposé de fabriquer des passeports dans lesquels une puce d'identification est intégrée à une feuille, par exemple une couverture, et est connectée à une antenne, réalisée dans l'épaisseur de cette feuille, grâce à laquelle cette puce peut communiquer avec l'extérieur sans contact (il n'y a donc pas de plot de contact apparent, ce qui assure une grande discrétion).

C'est ainsi que, selon une technique connue, un passeport est réalisé au moyen d'une antenne sérigraphiée (par exemple au moyen d'une encre conductrice à l'argent) directement sur la couverture. Une puce est ensuite montée, selon la technique dite « flip-chip » (c'est un montage après retournement, généralement effectué avec une plus grande précision qu'en montage normal, en aveugle), de telle sorte que certains, prédéterminés, de ses plots (« pads » en anglais) sont connectés électriquement à des terminaux appropriés de l'antenne.

En pratique, ces plots prédéterminés sont préalablement munis de bossages (parfois appelés « bumps » en anglais), qui constituent des saillies par rapport au niveau de ces plots et de ceux qui leur sont voisins, et qui garantissent en principe, notamment dans le cas d'un montage d'une puce dans une carte à puce (donc à support rigide), que les terminaux d'antenne, indépendamment de leur taille, ne viendront pas en contact avec ces plots adjacents à ceux qui doivent être effectivement connectés.

A titre d'exemple, le document US - 5 928 458 décrit le montage d'une puce électronique à un substrat en assurant simultanément la fixation et la connexion de cette puce au substrat, au moyen de bossages en or présentant une extrémité allongée de moindre rigidité que le reste du bossage, de manière à pouvoir se déformer lors de l'application sous pression du bossage vers une électrode, au travers d'une masse d'adhésif occupant tout l'espace entre la puce et ce substrat ; le document EP - 1 167 068 décrit une variante selon laquelle, pour assurer une bonne connexion alors que les électrodes présentent naturellement une couche d'oxyde, dans le cas d'électrodes en aluminium, les bossages comportent une pointe destinée à traverser cette couche d'oxyde.

Mais il s'avère que, dans un produit souple tel que la couverture d'un passeport, l'étape de réalisation de la connexion entre la puce et les terminaux d'antenne est perturbée par le fait que le support est mou (c'est en pratique du papier) et que les plots des puces peuvent être très proches. Lorsque l'on presse la puce contre les terminaux de l'antenne (donc contre le support mou), ce support peut ne se déformer (par enfoncement) que localement, de sorte que les portions latérales des terminaux, non enfoncées, peuvent créer des connexions intempestives avec des plots adjacents de la puce, malgré l'absence de bossages sur ceux-ci. Il en découle des risques de court-circuit alors que les contrôles de l'opération de connexion peuvent s'être révélés tout à fait satisfaisants.

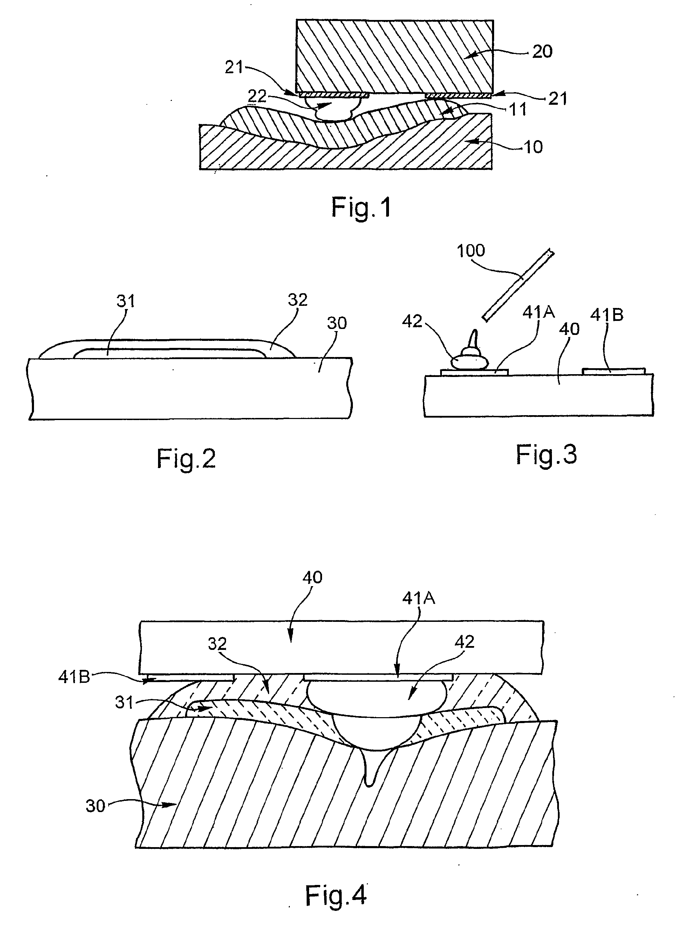

Une telle situation est représentée à la figure 1, où le support 10, recouvert localement d'un terminal 11 en encre conductrice, est incurvé lors de la pression vers le bas d'une puce 20 munie de plots 21 dont celui de gauche est muni d'un bossage 22 : ce bossage enfonce localement le support et l'encre, tandis qu'une portion latérale du terminal 11, moins enfoncée, vient en contact avec le plot 21 de droite. En fait, le terminal d'encre conductrice est ici représenté comme ayant une épaisseur sensiblement constante, mais il faut noter que, en fonction de la technologie utilisée pour déposer le terminal, notamment dans le cas de la sérigraphie, il peut se former en pratique des petits bourrelets d'encre latéraux (non représentés) dont la hauteur peut être de l'ordre de celle des bossages et qui génèrent donc aussi un risque de contact intempestif avec des plots adjacents.

La distance entre deux plots adjacents peut n'être en effet que de l'ordre de 60 microns alors que leur côté est de l'ordre de 80 microns, tandis que la surface des terminaux d'antenne peut aller jusqu'à de l'ordre du millimètre carré, avec une largeur qui est typiquement au moins égale à 150 microns (dans le cas d'une sérigraphie, en particulier avec une encre comportant des paillettes d'argent conductrices d'un diamètre de 80 microns). En pratique on peut considérer que le problème précité risque de se poser chaque fois qu'il y a des plots dont la distance (centre à centre) descend en dessous de 250 microns.

On pourrait penser à réduire les dimensions des terminaux, mais cela impliquerait d'augmenter très sérieusement les contraintes de positionnement, au point d'empêcher toute production réelle en série. Il est rappelé ici qu'une machine de placement de puce avec option de retournement (cas « flip-chip »), par exemple du genre de celles fabriquées par la société DATACON (leur coût peut être de l'ordre de 300.000 euros) comporte un système de reconnaissance automatique des plots sur la puce et de motifs d'alignement sur le support (un passeport dans l'exemple considéré). La machine récupère la puce (en pratique au sein d'un disque de l'ordre de 300 mm de diamètre, formé d'une multitude de puces similaires), la retourne et vient la placer sur le support en fonction des positions détectées. Compte tenu de ce qu'une telle ligne, dans une telle option de fonctionnement, est relativement lente (elle ne peut pas dépasser 1000 pièces à l'heure), il paraît rédhibitoire de renforcer encore les contraintes de positionnement.

On comprend que le même genre de problème peut se poser lorsque l'on souhaite utiliser des plots ou des terminaux en matériaux mous, même lorsque le matériau constitutif du support n'est pas particulièrement mou, ou encore lorsque la technique de formation des terminaux a fait apparaître des bourrelets latéraux importants, même sur un support rigide. Par ailleurs, le (ou les) terminal(aux) considéré(s) peut(peuvent) être connecté(s) à un ou plusieurs autres circuits différents d'une antenne, tels qu'un autre processeur, un écran, etc... ; de même la connexion en cause peut concerner non seulement des plots d'une puce mais aussi ceux d'un quelconque autre composant électronique, par exemple ceux précités.

L'invention a pour objet de pallier les inconvénients précités, et vise un procédé de montage d'un composant électronique, notamment une puce électronique, sur un support qui permette de minimiser les risques de connexion intempestive d'un plot du composant avec un terminal, même lorsque le support est mou ou lorsque la technique de formation du terminal risque de faire apparaître des bourrelets latéraux, tout en permettant une cadence satisfaisante de production en série, sans avoir à renforcer les contraintes habituelles de positionnement du composant vis-à-vis du support, voire en les allégeant. L'invention vise également une entité électronique comportant un composant électronique, tel qu'une puce électronique, monté sur un support, notamment mais pas nécessairement une pièce d'identité telle qu'un passeport, dont des plots du composant sont connectés de manière fiable à des terminaux formés sur le support, sans connexion intempestive entre un tel terminal et un autre plot, même lorsque le support est mou ou lorsque les terminaux comportent des bourrelets latéraux, et même lorsque le(s) terminal(aux) est(sont) de grande taille.

L'invention propose à cet effet un procédé de montage d'un composant électronique sur un support, tel que défini en revendication 1.

Ainsi, la connexion électrique entre un terminal et un plot qui doit lui être connecté est établie par un bossage dont ce plot est muni et qui, lors de la mise en contact du composant contre le support, traverse la couche isolante ; la couche isolante subsiste donc partout ailleurs et maintient l'isolation électrique entre ce terminal et tout autre plot qu'il n'est pas prévu de lui connecter (et qui n'a donc pas été muni d'un bossage).

L'invention s'applique tout particulièrement bien au cas où le composant est une puce électronique.

La présence de la couche isolante peut permettre de réduire les contraintes sur les conditions de mise en contact et de fixation du plot et du terminal par l'intermédiaire du bossage ; la fixation du bossage et du terminal a désormais moins de chances que dans les solutions connues de provoquer une connexion électrique intempestive entre ce terminal et un autre plot, surtout lorsque la formation des terminaux a pu faire apparaître des bourrelets latéraux. L'invention est tout particulièrement intéressante dans la cas où le support est en un matériau capable de s'écraser dans les conditions données de température et de pression, puisque c'est avec un tel type de support que peuvent se présenter les inconvénients décrits ci-dessus à propos de la fabrication de passeports.

Cette notion de support mou (on peut aussi dire qu'un tel support est compressible) peut recouvrir une large gamme de matériaux, qui comprend tout d'abord le cas des supports réalisés en un matériau fibreux, ce qui correspond à une large gamme de supports de coût modéré ; on y trouve en particulier les matériaux à base de papier, faciles à obtenir pour des coûts modérés. Un autre exemple intéressant de matériau pouvant être mou (si l'on choisit une épaisseur suffisamment faible) est celui des matières plastiques, par exemple le PVC. Il peut être noté à propos des supports mous qu'ils ont éventuellement, dans certains cas, la capacité d'être aussi en partie traversés, comme la couche isolante (et donc le terminal concerné) par le bossage, ce qui peut aboutir à un meilleur contact électrique avec ce terminal.

On comprend aisément que le procédé peut s'appliquer à des supports en feuille, et s'applique avantageusement à la réalisation de pièces d'identité (passeport, mais aussi, éventuellement, carte d'accès, carte d'identité, etc.).

En particulier, l'invention tire profit de bossages connus en soi (parfois désignés en anglais par « stud bumps »), obtenus par fusion de l'extrémité d'un fil fusible et qui ont une forme générale de boule (plus ou moins irrégulière) munie d'une portion en coin, voire en pointe, généralement considérée jusqu'ici comme étant plutôt un inconvénient. De manière préférée, l'épaisseur du bossage, sans la portion en coin, est comprisse entre 20 et 50 microns. En variante, le bossage peut comporter des portions pyramidales ou prismatiques. On comprend aisément que, plus la géométrie du bossage est pointue, plus la traversée de la couche isolante par celui-ci peut être assimilée à un percement de cette couche, qui peut se poursuivre jusque dans le matériau constitutif du terminal, voire du support.

De manière générale, le bossage est en or ou en alliage d'or, même si d'autres matériaux peuvent être considérés, tels que les alliages de cuivre par exemple.

De manière préférée, le support comporte au moins deux terminaux.

Les terminaux peuvent être réalisés par sérigraphie (voire par tampographie, ou flexographie). En variante, l'encre peut être déposée par héliogravure, offset, etc. ; on peut aussi prévoir de les obtenir en faisant croître un métal ou un alliage métallique (par exemple du cuivre) par exemple par électrolyse ; en pratique, les terminaux peuvent être formés en même temps que les pistes conductrices dont elles constituent les extrémités, par exemple les pistes d'une antenne. Il mérite d'être noté qu'on peut aussi, pour un certain nombre de supports souples, procéder à la formation des terminaux par une photogravure classique.

Compte tenu de la bonne isolation des terminaux par rapport à des plots non munis de bossages, l'invention permet de donner à ces terminaux une grande superficie, qui peut ainsi atteindre entre 66% et 95% de la surface du support qui est en regard de la puce électronique. Il en résulte une réduction sensible des contraintes de positionnement lors de la mise en contact. Préférentiellement, ces terminaux ont une superficie individuelle supérieure au millimètre carré.

Il n'y a pas de limite non plus à la superficie de la couche isolante, ce qui est tout à fait favorable à la minimisation des connexions intempestives. C'est ainsi qu'elle peut recouvrir les terminaux que comporte le support dans la région où le composant doit être monté. Elle peut même s'étendre au moins sur la majeure partie de la surface du support qui est en regard du composant électronique lors de l'étape de mise en contact. Cette couche peut être continue ou discontinue (en particulier, il y a avantageusement une séparation entre les portions de cette couche qui recouvrent, respectivement, les terminaux).

Dans un cas particulièrement intéressant, la couche isolante couvre au moins la majeure partie de cette antenne, auquel cas cette couche a, auprès du composant, une fonction isolante et, ailleurs, une fonction de protection, par exemple mécanique ou vis-à-vis de l'humidité, de l'antenne et de son support (surtout s'il est fibreux).

La couche isolante peut être réalisée en des matériaux divers.

En fait, sans vouloir être limité par une explication physique, la capacité de la couche isolante à être traversée (ce qui dépend essentiellement du matériau qui la constitue) peut être une capacité à s'évacuer latéralement, par une sorte de fluage, sous la poussée du bossage, ou une capacité à être perforé, selon la géométrie du bossage.

C'est ainsi que de manière avantageuse, la couche isolante est en un vernis isolant, ce qui correspond à une catégorie de matériaux bien connue. De manière préférée, ce vernis isolant est choisi en sorte d'avoir une énergie de polymérisation de moins de 1000 mJ/cm², de préférence de l'ordre de 500 mJ/cm², ce qui confère un faible retrait, et n'indult en pratique aucune ondulation du support après séchage et/ou refroidissement.

Mais la couche isolante peut aussi être une encre non-conductrice.

Qu'il s'agisse d'un vernis ou d'une encre isolante, la couche isolante peut notamment être déposée par sérigraphie. Cette couche isolante peut être mise à profit pour servir de support à un brin conducteur transversal formant pont conducteur entre deux pistes d'antenne à connecter en série (voir par exemple le document FR-2787609).

Mais la couche isolante peut aussi être un matériau fibreux, par exemple une fine feuille de papier (par exemple d'épaisseur de 15 microns).

En fait, quel que soit le matériau-constitutif de la couche isolante, son épaisseur est avantageusement comprise entre 5 et 25 microns, préférentiellement entre 10 et 15 microns.

Selon des caractéristiques avantageuses connues en soi dans la fabrication de cartes à puce, après l'étape de mise en contact, on remplit l'espace compris entre le support, muni de ses terminaux et de la couche isolante, et la puce électronique, d'une résine de remplissage, et/ou on noie la puce électronique dans une résine de protection.

Une entité électronique obtenue par le procédé de l'invention se reconnaît en ce que c'est une entité électronique conforme à la revendication 24.

Une telle entité électronique obtenue par le procédé de l'invention a avantageusement la particularité que le terminal s'étend en outre en regard d'un plot voisin du plot prédéterminé, ce plot voisin étant dépourvu de bossage et étant séparé du terminal au moins par ladite couche isolante.

D'autres caractéristiques avantageuses de cette entité correspondent aux caractéristiques avantageuses mentionnées ci-dessus à propos du procédé de l'invention.

Des objets, caractéristiques et avantages de l'invention ressortent de la description qui suit, donnée à titre d'exemple illustratif non limitatif, en regard des dessins annexés sur lesquels :
- la figure 1 est un schéma d'un détail d'une coupe de la zone de connexion entre un plot d'une puce et un terminal sous-jacent, selon l'état de la technique,
- la figure 2 est une vue en coupe d'un détail d'un support selon une première étape du procédé de l'invention,
- la figure 3 est une vue en coupe d'un détail d'une puce que l'on veut connecter au support de la figure 2, conformément à l'invention,
- la figure 4 est une vue de détail en coupe, analogue à celle de la figure 1, du résultat du montage selon l'invention de la puce électronique de la figure 3, après retournement, sur le support de la figure 2,
- la figure 5 est une vue schématique en coupe d'une entité électronique conforme à une variante de réalisation de l'invention,
- la figure 6 est une vue schématique en coupe d'une autre entité électronique, selon une autre variante de réalisation,
- la figure 7 est une vue de dessous de l'entité de la figure 6, dans le plan de la surface supérieure du support, et
- la figure 8 est une vue schématique en perspective d'un passeport dont une feuille comporte une puce montée sur un support conformément à la figure 5.

La figure 3 représente un composant électronique 40, ici une puce électronique, destiné à être montée, selon l'invention, sur le support 30 de la figure 2.

Le support 30 porte un terminal 31 (connecté à un circuit non représenté, également porté par le support, par exemple une antenne, voir ci-dessous). Selon l'invention, avant d'y monter la puce, on recouvre la surface de ce terminal d'une couche isolante 32.

Quant à la puce 40, elle comporte des plots de connexion, dont des plots 41A et 41 B, dont l'un, ici le plot 41A, est destiné à être connecté au terminal 31 ; ce plot est muni d'un bossage 42.

Le montage de la puce sur le support consiste à mettre le plot 41A muni de son bossage (après retournement de la puce vis-à-vis de sa configuration de la figure 3) en regard du terminal 32 du support, puis à mettre en contact ce bossage et ce terminal et à les fixer, dans des conditions de température et de pression prédéterminées, le matériau constitutif de la couche isolante étant tel que, dans lesdites conditions de température et de pression, le bossage traverse la couche isolante et établit la connexion du plot avec le terminal, sans pour autant dénuder le reste de la surface du terminal. En conséquence, bien que le support se soit quelque peu enfoncé à l'endroit où appuie le bossage 42, la couche isolante 32 empêche que la portion latérale gauche de ce terminal 31 vienne en contact avec le plot 41 B, à la différence de ce qui a été constaté à propos de la figure 1.

Dans l'exemple considéré, le support est en effet avantageusement réalisé en un matériau capable de s'écraser dans les conditions de température et de pression, c'est-à-dire que l'invention peut s'appliquer à des matériaux mous, tels que des matériaux fibreux, avantageusement en forme de feuille. C'est ainsi que le support peut être notamment du papier. Il s'agit par exemple du papier vendu par la société FIBER MARK sous la désignation SECURALIN ®. En variante il peut s'agir aussi d'un matériau fibreux du type papier à fibres synthétiques, etc.

En variante, ce support est une feuille de matière plastique, par exemple du PVC, d'une épaisseur avantageusement inférieure à 200 microns.

Ainsi qu'on le verra plus loin le choix du papier, ou d'une matière plastique, permet notamment que l'invention puisse s'appliquer à une pièce d'identité.

Le bossage dont le plot à connecter est muni peut être un bossage de forme quelconque, par exemple globalement parallélépipédique (obtenu par exemple par croissance électrolytique), mais, de manière avantageuse, il a une forme qui se rétrécit à l'opposé du plot, en sorte de faciliter la traversée de la couche isolante lors de l'étape de mise en contact/fixation.

Cette forme peut ainsi être celle d'une boule, sphérique ou aplatie.

Toutefois, de manière préférée, ce bossage comporte une portion en coin (par exemple une portion prismatique ou pyramidale), voire une portion en pointe. C'est ainsi que le bossage est avantageusement du type appelé « stud bump » en anglais, c'est-à-dire qu'il est obtenu par fusion de l'extrémité d'un fil fusible, grâce à quoi ce bossage a la forme d'une boule qui comporte une portion en pointe. L'obtention d'un tel bossage est schématisée à la figure 3 où l'on voit le fil 100 dont on vient de détacher une petite masse formant le bossage 42. Ce bossage peut être obtenu par une machine de soudure ultrasonique, en commençant par placer le fil dans un tube capillaire ; on définit une boule en faisant fondre le bout du fil par une décharge électrique et on vient écraser ensuite cette boule contre le plot. Le tube capillaire a une forme telle qu'on crée une petite queue lorsque le capillaire remonte et que le fil se casse à sa jonction avec la boule. Le diamètre d'un tel bossage est typiquement de 25 microns ou de 32 microns en fonction des conditions opératoires ou des fils.

Un bossage tel que celui de la figure 3 a, sans la portion en coin (à savoir la queue précité), une épaisseur qui est typiquement de l'ordre de 20 à 50 microns, par exemple de 40 microns environ.

Il mérite d'être noté sur la figure 4 que, non seulement le bossage traverse la couche isolante, mais il traverse en outre la couche formant le terminal et pénètre dans le support lui-même, ce qui assure un très bon contact électrique, avec une très bonne tenue mécanique de cette liaison

Le bossage est avantageusement en or ou en alliage d'or, étant bien entendu que d'autres matériaux conducteurs peuvent être utilisés.

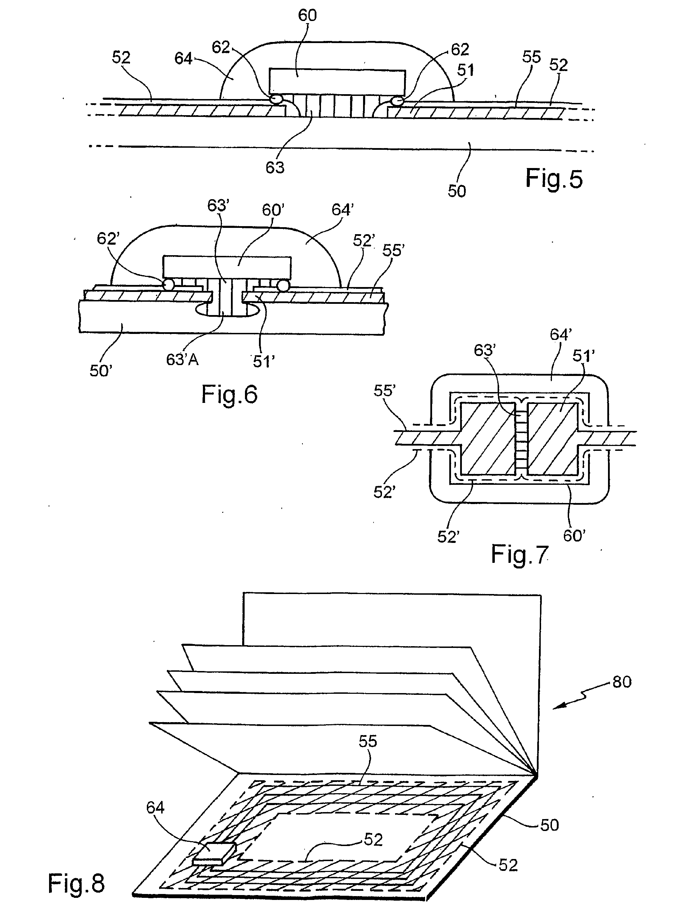

La figure 5 représente une entité électronique obtenue par le procédé qui vient d'être décrit, avec toutefois des variantes.

Cette figure 5 représente un support 50 sur lequel une puce 60 a été montée. Ce support est représenté avec deux terminaux 51 se prolongeant à droite comme à gauche par une piste conductrice 55.

Ces terminaux sont ici tous deux recouverts par la couche isolante 52. Toutefois, celle-ci est ici discontinue en ce sens qu'elle ne s'étend pas sur la surface du support entre ces deux terminaux ; cette couche isolante s'étend néanmoins ici sur au moins la majeure partie de la surface du support (recouverte ou non par les terminaux) en regard de la puce ; elle s'étend ici en outre sur des portions de piste 55 dont ces terminaux sont des prolongements.

Avant ou après la mise en contact des bossages 62 avec les terminaux 51 (les plots ne sont pas représentés), il y a avantageusement dépose d'une résine de remplissage 63, en sorte de remplir l'espace compris entre le support, muni de ses terminaux et de la couche isolante, et la puce électronique ; cette résine de remplissage 63 est parfois appelée en anglais « underfill ». Par ailleurs on a en outre noyé la puce électronique dans une résine de protection 64. La présence de telles résines de remplissage et/ou de protection étant connue en soi dans le domaine des cartes à puce, elles ne seront pas détaillées ici.

Les figures 6 et 7 représentent une variante de réalisation de l'entité électronique de la figure 5. Les éléments de l'entité de ces figures 6 et 7 qui sont analogues à ceux de l'entité de la figure 5 y sont affectés par les mêmes signes de référence, quoique suivis de l'indice « prime ».

On observe que les terminaux 51' sont de plus grande taille que sur la figure 5, au point de recouvrir entre 66% et 95% de la surface du support qui est en regard de la puce électronique (en laissant subsister, bien sûr, un espace entre les terminaux pour éviter tout court-circuit entre eux). La superficie de ces terminaux peut dépasser le millimètre carré.

En outre, la couche isolante 52' s'étend, comme celle de la couche 52 de la figure 5, sur la quasi-totalité de la surface du support en regard de la puce ainsi que sur des portions de piste 55 aboutissant à ces terminaux 51, avec ici aussi un espacement entre ses portions respectives couvrant les terminaux. Par contre, la résine de remplissage 63' s'étend ici en outre dans la masse du support, entre les terminaux, au point de provoquer un ancrage 63'A dans le support. Bien entendu, cet ancrage est représenté avec une profondeur tout à fait exagérée, et ne peut se produire notamment qu'avec un support capable d'être mouillé par cette résine de remplissage.

La couche isolante peut s'étendre sur une surface aussi grande qu'on peut le souhaiter pour de raisons de protection ou pour toute autre raison.

C'est ainsi que, sur la figure 8, où le support 52 de la figure 5 est représenté sous la forme de la couverture, par exemple en papier, d'un document d'identité, ici un passeport, la puce (on ne la distingue pas dans la masse de résine de protection 64) est connectée, par l'intermédiaire des terminaux, à un circuit également porté par ce support, ici une antenne 55. La couche isolante s'étend non seulement entre la puce et les terminaux (sauf là où elle est traversée par les bossages) mais en outre sur la totalité de l'antenne.

La couche isolante peut être de diverses natures. C'est ainsi qu'elle peut être réalisée en un vernis isolant, ce qui correspond à un type de matériau facile à poser ; on sait le déposer et le faire sécher par des techniques bien maîtrisées. Ce vernis est avantageusement choisi en sorte d'avoir une énergie de polymérisation de moins de 1000 mJ/cm², préférentiellement de l'ordre de 500 mJ/cm², ce qui confère à ce vernis isolant un faible retrait, et minimise donc les phénomènes d'ondulations qui peuvent affecter la feuille après le montage et la fixation de la puce. Ce vernis est par exemple un vernis connu sous l'appellation ACHESON PF455.

En variante non représentée, la couche isolante peut aussi être réalisée à l'aide d'une encre non conductrice.

Cette couche isolante peut être déposée par sérigraphie. En variante on peut procéder par pulvérisation.

Mais cette couche peut aussi être réalisée en un matériau fibreux, par exemple en papier (par exemple une fine feuille de 15 microns d'épaisseur).

Quelle que soit sa composition, cette couche isolante a typiquement une épaisseur comprise entre 5 et 25 microns, préférentiellement entre 10 et 15 microns, ce qui est un bon compromis pour permettre une traversée par les bossages tout en maintenant ailleurs une bonne isolation électrique.

Les conditions de température et de pression appliquées lors du montage de la puce peuvent être, dans le cas considéré d'un vernis, les conditions de polymérisation de la résine constituant ce vernis, par exemple : tête chauffante à 180°C, sous une pression de 370 grammes pendant 8 secondes. Toutefois, de manière avantageuse, la température de la table supportant la feuille formant le support est réduite aux alentours de 45 °C (une température de 60°C permet en principe de compenser les pertes, mais peut se révéler trop élevée pour éviter un ramollissement du vernis qui pourrait alors gêner la traversée par les bossages).

On appréciera que selon l'invention :
- on ne connecte que les plots qui doivent l'être,
- il n'y a pas d'impératif sur la taille des terminaux,
- les contraintes de positionnement de la puce sont très modérées, typiquement à +/- 0.5 mm,
- il est même possible de déposer les puces en aveugle, (la machine n'a plus besoin de savoir reconnaître les plots sur la puce,
- il n'est plus nécessaire d'avoir la précision de positionnement des machines ayant l'option « flip-chip » (il suffit de positionner les puces en configuration déjà retournée), ce qui permet à la fois d'utiliser des machines moins coûteuses que les machines de grande précision capables d'effectuer un tel retournement, et d'atteindre des cadences élevées, par exemple de l'ordre de 5000 puces à l'heure,
- un même matériau (celui de la couche isolante) permet à la fois une bonne isolation à proximité de la puce, et une bonne protection du circuit auquel mènent les terminaux.

## Revendications

1. Procédé de montage d'un composant électronique sur un support, selon lequel :
* on prend un composant électronique (40, 60, 60') comportant des plots de connexion, dont au moins un plot (41A), prédéterminé, est muni d'un bossage (42, 62, 62') dont la forme se rétrécit à l'opposé du plot,
* on prend un support (30, 50, 50') comportant au moins une antenne ayant au moins un terminal d'antenne (31, 51, 51') à connecter électriquement audit plot prédéterminé par l'intermédiaire dudit bossage,
* on met en regard ce plot prédéterminé muni du bossage et ce terminal, on met en contact ce bossage et ce terminal et on les fixe l'un à l'autre, dans des conditions données de température et de pression, **caractérisé en ce que** le support est mou, en un matériau capable de s'écraser dans lesdites conditions données de température et de pression, le terminal est réalisé à l'aide d'une encre conductrice, **en ce que**, avant de mettre en contact et de fixer ce bossage et ce terminal, on recouvre la surface de ce terminal par une couche isolante (32, 52, 52'), cette couche isolante étant en un matériau choisi en sorte d'être traversé par ce bossage, grâce à la forme de ce bossage, dans lesdites conditions de température et de pression et **en ce que**, avant ou après l'étape de mise en contact, on dépose une résine de remplissage en sorte de remplir l'espace compris entre le support, muni de ses terminaux et de la couche isolante, et le composant électronique.

2. Procédé selon la revendication 1, **caractérisé en ce que** le composant est une puce électronique.

3. Procédé selon la revendication 1 ou la revendication 2, **caractérisé en ce que** le terminal s'étend en outre en regard d'un plot voisin du plot choisi, ce plot voisin étant dépourvu de bossage en étant séparé du terminal au moins par ladite couche isolante.

4. Procédé selon l'une quelconque des revendications 1 à 3, **caractérisé en ce que** le support est réalisé en un matériau fibreux.

5. Procédé selon la revendication 4, **caractérisé en ce que** le support est réalisé en un matériau à base de papier.

6. Procédé selon l'une quelconque des revendications 1 à 3, **caractérisé en ce que** le support est réalisé en une matière plastique.

7. Procédé selon l'une quelconque des revendications 1 à 6, **caractérisé en ce que** le support fait partie d'une pièce d'identité.

8. Procédé selon la revendication 7, selon lequel le support fait partie d'un passeport.

9. Procédé selon l'une quelconque des revendications 1 à 8, **caractérisé en ce que** ledit bossage est formé par fusion de l'extrémité d'un fil fusible, grâce à quoi ce bossage a la forme d'une boule qui comporte une portion en coin.

10. Procédé selon la revendication 9, **caractérisé en ce que** l'épaisseur du bossage, sans la portion en coin, est comprise entre 20 et 50 microns.

11. Procédé selon l'une quelconque des revendications 1 à 10, **caractérisé en ce que** l'on fait traverser la couche isolante et le terminal par le bossage jusqu'à pénétrer dans le support.

12. Procédé selon l'une quelconque des revendications 1 à 11, **caractérisé en ce que** le bossage est en or ou en alliage d'or.

13. Procédé selon l'une quelconque des revendications 1 à 12, **caractérisé en ce que** le support comporte au moins deux terminaux et ces terminaux recouvrent entre 66% et 95% de la surface du support qui est en regard du composant électronique.

14. Procédé selon la revendication 13, **caractérisé en ce que** la couche isolante, continue ou non, recouvre ces terminaux.

15. Procédé selon la revendication 14, **caractérisé en ce que** la couche isolante s'étend au moins sur la majeure partie de la surface du support qui est en regard du composant électronique lors de l'étape de mise en contact.

16. Procédé selon l'une quelconque des revendications 1 à 15, **caractérisé en ce que** la couche isolante couvre au moins la majeure partie de cette antenne.

17. Procédé selon l'une quelconque des revendications 1 à 16, **caractérisé en ce que** ce terminal d'antenne est formé par sérigraphie.

18. Procédé selon l'une quelconque des revendications 1 à 17, **caractérisé en ce que** la couche isolante est en un vernis isolant.

19. Procédé selon la revendication 18, **caractérisé en ce que** ce vernis isolant est choisi en sorte d'avoir une énergie de polymérisation de moins de 1000 mJ/cm², ce qui confère un faible retrait.

20. Procédé selon la revendication 19, **caractérisé en ce que** le vernis isolant a une énergie de polymérisation de l'ordre de 500 mJ/cm².

21. Procédé selon l'une quelconque des revendications 1 à 20, **caractérisé en ce qu'**on dépose cette couche isolante par sérigraphie.

22. Procédé selon l'une quelconque des revendications 1 à 17, **caractérisé en ce que** cette couche isolante est en une encre non conductrice ou un matériau fibreux.

23. Procédé selon l'une quelconque des revendications 1 à 22, **caractérisé en ce que** l'épaisseur de la couche isolante est comprise entre 5 et 25 microns, préférentiellement entre 10 et 15 microns.

24. Entité électronique comportant un composant électronique sur un support, ce support (30, 50, 50') comportant une antenne ayant au moins un terminal d'antenne (31, 51, 51') et ce composant électronique (40, 60, 60') comportant des plots dont l'un au moins (41A), prédéterminé, est muni d'un bossage (42, 62, 62') connectant électriquement ce plot à ce terminal en ayant une forme qui se rétrécit à l'opposé du plot, **caractérisée en ce que** le support est mou, en un matériau capable de s'écraser, ce terminal est réalisé à l'aide d'une encre conductrice et est recouvert d'une couche isolante (32, 52, 52') traversée par le bossage, une résine de remplissage (63) remplissant l'espace compris entre le support, muni de ses terminaux et de la couche isolante, et le composant électronique.

25. Entité électronique selon la revendication 24, **caractérisée en ce que** le composant électronique est une puce électronique.

26. Entité électronique selon la revendication 24 ou la revendication 25, **caractérisée en ce que** le terminal s'étend en outre en regard d'un plot voisin du plot choisi, ce plot voisin étant dépourvu de bossage et étant séparé du terminal au moins par ladite couche isolante.

27. Entité électronique selon l'une quelconque des revendications 24 à 26, **caractérisée en ce que** le support est réalisé en un matériau fibreux.

28. Entité électronique selon la revendication 27, **caractérisée en ce que** le support est réalisé en un matériau à base de papier.

29. Entité électronique selon l'une quelconque des revendications 24 à 26, **caractérisée en ce que** le support est réalisé en une matière plastique.

30. Entité électronique selon l'une quelconque des revendications 24 à 29, **caractérisée en ce que** le support fait partie d'une pièce d'identité.

31. Entité électronique selon la revendication 30, **caractérisée en ce que** le support fait partie de la couverture d'un passeport.

32. Entité électronique selon l'une quelconque des revendications 24 à 31, **caractérisée en ce que** ledit bossage a la forme d'une boule qui comporte une portion en coin.

33. Entité électronique selon la revendication 32, **caractérisée en ce que** l'épaisseur du bossage, sans la portion en coin, est comprise entre 20 et 50 microns.

34. Entité électronique selon l'une quelconque des revendications 24 à 33, **caractérisée en ce que** le bossage traverse la couche isolante et le terminal jusqu'à pénétrer dans le support.

35. Entité électronique selon l'une quelconque des revendications 24 à 34, **caractérisée en ce que** le bossage est en or ou en alliage d'or.

36. Entité électronique selon l'une quelconque des revendications 24 à 35, **caractérisée en ce que** le support comporte au moins deux terminaux et ces terminaux recouvrent entre 66% et 95% de la surface du support qui est en regard du composant électronique.

37. Entité électronique selon la revendication 36, **caractérisée en ce que** la couche isolante, continue ou non, recouvre ces terminaux.

38. Entité électronique selon la revendication 37, **caractérisée en ce que** la couche isolante s'étend au moins sur la majeure partie de la surface du support qui est en regard du composant électronique.

39. Entité électronique selon l'une quelconque des revendications 24 à 38, **caractérisée en ce que** la couche isolante couvre au moins la majeure partie de cette antenne.

40. Entité électronique selon l'une quelconque des revendications 24 à 39, **caractérisé en ce que** ce terminal d'antenne réalisé avec une encre conductrice est obtenu par sérigraphie.

41. Entité électronique selon l'une quelconque des revendications 24 à 40, **caractérisée en ce que** la couche isolante est en un vernis isolant.

42. Entité électronique selon la revendication 41, **caractérisée en ce que** ce vernis isolant a une énergie de polymérisation de moins de 1000 mJ/cm².

43. Entité électronique selon la revendication 42, **caractérisée en ce que** le vernis isolant a une énergie de polymérisation de l'ordre de 500 mJ/cm².

44. Entité électronique selon l'une quelconque des revendications 24 à 40, **caractérisé en ce que** la couche isolante est en une encre non conductrice ou en un matériau fibreux.

45. Entité électronique selon l'une quelconque des revendications 24 à 44, **caractérisée en ce que** cette couche isolante est déposée par sérigraphie.

46. Entité électronique selon l'une quelconque des revendications 24 à 45, **caractérisée en ce que** l'épaisseur de la couche isolante est comprise entre 5 et 25 microns, préférentiellement entre 10 et 15 microns.

## Patentansprüche

1. Verfahren zur Anbringung einer elektronischen Komponente auf einem Träger, bei dem:
* eine elektronische Komponente (40, 60, 60') genommen wird, umfassend Anschlussstücke, wobei mindestens ein vorbestimmtes Anschlussstück (41A) mit einem Wulst (42, 62, 62') versehen ist, dessen Form sich gegenüber dem Anschlussstück zurückzieht,
* ein Träger (30, 50, 50') genommen wird, umfassend mindestens eine Antenne, die mindestens ein Antennenterminal (31, 51, 51') aufweist, das elektrisch an das vorbestimmte Anschlussstück mit Hilfe des Wulstes anzuschließen ist,
* dieses vorbestimmte Anschlussstück, das mit dem Wulst versehen ist, und dieses Terminal einander gegenüber angeordnet werden, dieser Wulst und dieses Terminal in Kontakt gebracht und aneinander unter gegebenen Temperatur- und Druckbedingungen befestigt werden, **dadurch gekennzeichnet, dass** der Träger weich ist, aus einem Material, das geeignet ist, sich unter den gegebenen Temperatur- und Druckbedingungen zusammenzudrücken, das Terminal mit Hilfe einer leitfähigen Tinte hergestellt ist, dass, bevor dieser Wulst und dieses Terminal in Kontakt gebracht und befestigt werden, die Oberfläche dieses Terminals mit einer Isolierschicht (32, 52, 52') überzogen wird, wobei diese Isolierschicht aus einem derart ausgewählten Material ist, dass es von diesem Wulst dank der Form dieses Wulstes unter den Temperatur- und Druckbedingungen durchquert wird, und dass vor oder nach dem Schritt der Kontaktnahme ein Füllharz aufgebracht wird, um den Raum zwischen dem Träger, der mit seinem Terminals und der Isolierschicht versehen ist, und der elektronischen Komponente aufzufüllen.

2. Verfahren nach Anspruch 1, **dadurch gekennzeichnet, dass** die Komponente ein elektronischer Chip ist.

3. Verfahren nach Anspruch 1 oder Anspruch 2, **dadurch gekennzeichnet, dass** sich das Terminal ferner gegenüber einem benachbarten Anschlussstück des ausgewählten Anschlussstücks erstreckt, wobei dieses benachbarte Anschlussstück keinen Wulst besitzt, wobei es von dem Terminal zumindest durch die Isolierschicht getrennt ist.

4. Verfahren nach einem der Ansprüche 1 bis 3, **dadurch gekennzeichnet, dass** der Träger aus einem faserigen Material hergestellt ist.

5. Verfahren nach Anspruch 4, **dadurch gekennzeichnet, dass** der Träger aus einem Material auf Basis von Papier hergestellt ist.

6. Verfahren nach einem der Ansprüche 1 bis 3, **dadurch gekennzeichnet, dass** der Träger aus einem Kunststoff hergestellt ist.

7. Verfahren nach einem der Ansprüche 1 bis 6, **dadurch gekennzeichnet, dass** der Träger Teil eines Identitätsnachweises ist.

8. Verfahren nach Anspruch 7, bei dem der Träger Teil eines Reisepasses ist.

9. Verfahren nach einem der Ansprüche 1 bis 8, **dadurch gekennzeichnet, dass** der Wulst durch Schmelzen eines Schmelzdrahtes gebildet ist, dank dessen dieser Wulst die Form einer Kugel hat, die einen Keilabschnitt umfasst.

10. Verfahren nach Anspruch 9, **dadurch gekennzeichnet, dass** die Dicke des Wulstes ohne Keilabschnitt zwischen 20 und 50 Mikrometer beträgt.

11. Verfahren nach einem der Ansprüche 1 bis 10, **dadurch gekennzeichnet, dass** die Isolierschicht und das Terminal von dem Wulst durchquert werden, bis er in den Träger eindringt.

12. Verfahren nach einem der Ansprüche 1 bis 11, **dadurch gekennzeichnet, dass** der Wulst aus Gold oder einer Goldlegierung ist.

13. Verfahren nach einem der Ansprüche 1 bis 12, **dadurch gekennzeichnet, dass** der Träger mindestens zwei Terminals umfasst, und diese Terminals zwischen 66 % und 95 % der Oberfläche des Trägers, die der elektronischen Komponente gegenüberliegt, bedecken.

14. Verfahren nach Anspruch 13, **dadurch gekennzeichnet, dass** die Isolierschicht, die durchgehend ist oder nicht, diese Terminals bedeckt.

15. Verfahren nach Anspruch 14, **dadurch gekennzeichnet, dass** sich die Isolierschicht zumindest auf dem größten Teil der Oberfläche des Trägers, die der elektronischen Komponente beim Schritt der Kontaktherstellung gegenüberliegt, erstreckt.

16. Verfahren nach einem der Ansprüche 1 bis 15, **dadurch gekennzeichnet, dass** die Isolierschicht zumindest den größten Teil dieser Antenne bedeckt.

17. Verfahren nach einem der Ansprüche 1 bis 16, **dadurch gekennzeichnet, dass** dieses Antennenterminal durch Serigraphie hergestellt ist.

18. Verfahren nach einem der Ansprüche 1 bis 17, **dadurch gekennzeichnet, dass** die Isolierschicht ein Isolierlack ist.

19. Verfahren nach Anspruch 18, **dadurch gekennzeichnet, dass** dieser Isolierlack derart ausgewählt ist, dass eine Polymerisationsenergie von mindestens 1000 mJ/cm² vorhanden ist, die eine geringe Schrumpfung verleiht.

20. Verfahren nach Anspruch 19, **dadurch gekennzeichnet, dass** der Isolierlack eine Polymerisationsenergie von ungefähr 500 mJ/cm² hat.

21. Verfahren nach einem der Ansprüche 1 bis 20, **dadurch gekennzeichnet, dass** diese Isolierschicht durch Serigraphie aufgebracht ist.

22. Verfahren nach einem der Ansprüche 1 bis 17, **dadurch gekennzeichnet, dass** diese Isolierschicht eine nicht leitfähige Tinte oder ein faseriges Material ist.

23. Verfahren nach einem der Ansprüche 1 bis 22, **dadurch gekennzeichnet, dass** die Dicke der Isolierschicht zwischen 5 und 25 Mikrometer, vorzugsweise zwischen 10 und 15 Mikrometer, beträgt.

24. Elektronische Einheit, umfassend eine elektronische Komponente auf einem Träger, wobei dieser Träger (30, 50, 50') eine Antenne umfasst, die mindestens ein Antennenterminal (31, 51, 51') umfasst, und wobei diese elektronische Komponente (40, 60, 60') Anschlussstücke umfasst, von denen mindestens ein vorbestimmtes (41A) mit einem Wulst (42, 62, 62') versehen ist, der dieses Anschlussstück elektrisch an dieses Terminal anschließt, wobei er eine Form hat, die sich gegenüber dem Anschlussstück zurückzieht, **dadurch gekennzeichnet, dass** der Träger weich ist, aus einem Material, das geeignet ist, sich zusammenzudrücken, wobei dieses Terminal mit Hilfe einer leitfähigen Tinte hergestellt und mit einer Isolierschicht (32, 52, 52'), durch die der Wulst hindurchgeht, überzogen ist, wobei ein Füllharz (63) den Raum zwischen dem Träger, der mit seinem Terminals und der Isolierschicht versehen ist, und der elektronischen Komponente ausfüllt.

25. Elektronische Einheit nach Anspruch 24, **dadurch gekennzeichnet, dass** die elektronische Komponente ein elektronischer Chip ist.

26. Elektronische Einheit nach Anspruch 24 oder Anspruch 25, **dadurch gekennzeichnet, dass** sich das Terminal ferner gegenüber einem benachbarten Anschlussstück des ausgewählten Anschlussstücks erstreckt, wobei dieses benachbarte Anschlussstück keinen Wulst besitzt, wobei es von dem Terminal zumindest durch die Isolierschicht getrennt ist.

27. Elektronische Einheit nach einem der Ansprüche 24 bis 26, **dadurch gekennzeichnet, dass** der Träger aus einem faserigen Material hergestellt ist.

28. Elektronische Einheit nach Anspruch 27, **dadurch gekennzeichnet, dass** der Träger aus einem Material auf Basis von Papier hergestellt ist.

29. Elektronische Einheit nach einem der Ansprüche 24 bis 26, **dadurch gekennzeichnet, dass** der Träger aus einem Kunststoff hergestellt ist.

30. Elektronische Einheit nach einem der Ansprüche 24 bis 29, **dadurch gekennzeichnet, dass** der Träger Teil eines Identitätsnachweises ist.

31. Elektronische Einheit nach Anspruch 30, bei dem der Träger Teil der Verkleidung eines Reisepasses ist.

32. Elektronische Einheit nach einem der Ansprüche 24 bis 31, **dadurch gekennzeichnet, dass** der Wulst durch Schmelzen eines Schmelzdrahtes gebildet ist, dank dessen dieser Wulst die Form einer Kugel hat, die einen Keilabschnitt umfasst.

33. Elektronische Einheit nach Anspruch 32, **dadurch gekennzeichnet, dass** die Dicke des Wulstes ohne Keilabschnitt zwischen 20 und 50 Mikrometer beträgt.

34. Elektronische Einheit nach einem der Ansprüche 24 bis 33, **dadurch gekennzeichnet, dass** die Isolierschicht und das Terminal von dem Wulst durchquert werden, bis er in den Träger eindringt.

35. Elektronische Einheit nach einem der Ansprüche 24 bis 34, **dadurch gekennzeichnet, dass** der Wulst aus Gold oder einer Goldlegierung ist.

36. Elektronische Einheit nach einem der Ansprüche 24 bis 35, **dadurch gekennzeichnet, dass** der Träger mindestens zwei Terminals umfasst, und diese Terminals zwischen 66 % und 95 % der Oberfläche des Trägers, die der elektronischen Komponente gegenüberliegt, bedecken.

37. Elektronische Einheit nach Anspruch 36, **dadurch gekennzeichnet, dass** die Isolierschicht, die durchgehend ist oder nicht, diese Terminals bedeckt.

38. Elektronisch Einheit nach Anspruch 37, **dadurch gekennzeichnet, dass** sich die Isolierschicht zumindest auf dem größten Teil der Oberfläche des Trägers, die der elektronischen Komponente gegenüberliegt, erstreckt.

39. Elektronische Einheit nach einem der Ansprüche 24 bis 38, **dadurch gekennzeichnet, dass** die Isolierschicht zumindest den größten Teil dieser Antenne bedeckt.

40. Elektronische Einheit nach einem der Ansprüche 24 bis 39, **dadurch gekennzeichnet, dass** dieses Antennenterminal durch Serigraphie hergestellt ist.

41. Elektronische Einheit nach einem der Ansprüche 24 bis 40, **dadurch gekennzeichnet, dass** die Isolierschicht ein Isolierlack ist.

42. Elektronische Einheit nach Anspruch 41, **dadurch gekennzeichnet, dass** der Isolierlack eine Polymerisationsenergie von mindestens 1000 mJ/cm² aufweist.

43. Elektronische Einheit nach Anspruch 42, **dadurch gekennzeichnet, dass** der Isolierlack eine Polymerisationsenergie von ungefähr 500 mJ/cm² aufweist.

44. Elektronische Einheit nach einem der Ansprüche 24 bis 40, **dadurch gekennzeichnet, dass** die Isolierschicht aus einer nicht leitfähigen Tinte oder einem faserigen Material ist.

45. Elektronische Einheit nach einem der Ansprüche 24 bis 44, **dadurch gekennzeichnet, dass** diese Isolierschicht durch Serigraphie aufgebracht ist.

46. Elektronische Einheit nach einem der Ansprüche 24 bis 45, **dadurch gekennzeichnet, dass** die Dicke dieser Isolierschicht zwischen 5 und 25 Mikrometer, vorzugsweise zwischen 10 und 15 Mikrometer, beträgt.

## Claims

1. Method of mounting an electronic component on a support, wherein:
* an electronic component (40, 60, 60') is taken that includes connection pads, including at least one predetermined pad (41A) provided with a boss (42, 62, 62'), which has a shape that gets smaller in the direction away from the pad,
* a support (30, 50, 50') is taken that includes at least on antenna having at least an antenna terminal (31, 51, 51') to be electrically connected to said predetermined pad through the intermediary of said boss,
* this predetermined pad provided with the boss and this terminal are placed facing each other, this boss and this terminal are brought into contact and they are fixed the one to the other, under given conditions of temperature and of pressure,
**characterized in that** the support is soft, made of a material capable of being crushed under said conditions of temperature and pressure, the terminal is made of a conducting ink, **in that**, before bringing this boss and this terminal into contact and fixing them, the surface of this terminal is covered by an insulative layer (32, 52, 52'), this insulative layer being of a material chosen to have this boss pass through it thanks to the shape of this boss under said conditions of temperature and pressure and **in that**, before or after the step of bringing into contact, a filter resin is deposited so as to fill the space between the support provided with its terminals and the insulative layer, and the electronic component.

2. Method according to claim 1, **characterized in that** the component is an electronic chip.

3. Method according to claim 1 or claim 2, **characterized in that** the terminal also faces a pad adjacent to the chosen pad, that adjacent pad having no boss and being separated from the terminal at least by said insulative layer.

4. Method according to any one of claims 1 to 3, **characterized in that** the support is made of a fibrous material.

5. Method according to claim 4, **characterized in that** the support is made of a paper-based material.

6. Method according to any one of claims 1 to 3, **characterized in that** the support is made of a plastic material.

7. Method according to any one of claims 1 to 6, **characterized in that** the support is part of an identity document.

8. Method according to claim 7 wherein the support is part of a passport.

9. Method according to any of claims 1 to 8, **characterized in that** said boss is formed by melting the end of a fusible wire, thanks to which this boss has the shape of a ball that includes a wedge-shaped portion.

10. Method according to claim 9, **characterized in that** the thickness of the boss, without the wedge-shaped portion, is from 20 to 50 microns.

11. Method according to any one of claims 1 to 10, **characterized in that** the boss is caused to pass through the insulative layer and the terminal until it penetrates into the support.

12. Method according to any one of claims 1 to 11, **characterized in that** the boss is of gold or of gold alloy.

13. Method according to any one of claims 1 to 12, **characterized in that** the support includes at least two terminals and these terminals cover from 66% to 95% of the surface of the support that faces the electronic component.

14. Method according to claim 13, **characterized in that** the insulative layer, continuous or not, covers these terminals.

15. Method according to claim 14, **characterized in that** the insulative layer extends at least over the major portion of the surface of the support that faces the electronic component during the step of bringing into contact.

16. Method according to any one of claims 1 to 15, **characterized in that** the insulative layer covers at least the major portion of this antenna.

17. Method according to any one of claims 1 to 16, **characterized in that** the antenna terminal is formed by screenprinting.

18. Method according to any one of claims 1 to 17, **characterized in that** the insulative layer is an insulative varnish.

19. Method according to claim 18, **characterized in that** this insulative varnish is selected to have a polymerization energy of less than 1000 mJ/cm², which confers on it a low shrinkage.

20. Method according to claim 19, **characterized in that** the insulative varnish has a polymerization energy of the order of 500 mJ/cm².

21. Method according to any one of claims 1 to 20, **characterized in that** this insulative layer is deposited by screenprinting.

22. Method according to any one of claims 1 to 17, **characterized in that** this insulative layer is a non-conducting ink or a fibrous material.

23. Method according to any one of claims 1 to 22, **characterized in that** the thickness of the insulative layer is from 5 to 25 microns, preferably from 10 to 15 microns.

24. Electronic entity including an electronic component on a support, that support (30, 50, 50') including an antenna having at least one antenna terminal (31, 51, 51') and that electronic component (40, 60, 60') including pads at least one of which (41A), predetermined, is provided with a boss (42, 62, 62') electrically connecting that pad to that terminal, by having a shape that gets smaller in the direction away from the pad, **characterized in that** the support is soft, made of a material capable of being crashed, that terminal is made of a non-conducting ink and is covered with an insulative layer (32, 52, 52') through which the boss passes, a filler resin (63) filling the space between the support provided with its terminals and the insulative layer, and the electronic component.

25. Electronic entity according to claim 24, **characterized in that** the electronic component is an electronic chip.

26. Electronic entity according to claim 24 or claim 25, **characterized in that** the terminal also faces a pad adjacent to the chosen pad, that adjacent pad having no boss and being separated from the terminal at least by said insulative layer.

27. Electronic entity according to any one of claims 24 to 26, **characterized in that** the support is made of a fibrous material.

28. Electronic entity according to claim 27, **characterized in that** the support is made of a paper-based material.

29. Electronic entity according to any one of claims 24 to 26, **characterized in that** the support is made of a plastic material.

30. Electronic entity according to any one of claims 24 to 29, **characterized in that** the support is part of an identity document.

31. Electronic entity according to claim 30, **characterized in that** the support is part of the cover of a passport.

32. Electronic entity according to any one of claims 24 to 31, **characterized in that** said boss has the shape of a ball which includes a wedge-shaped portion.

33. Electronic entity according to claim 32, **characterized in that** the thickness of the boss, without the wedge-shaped portion, is from 20 to 50 microns.

34. Electronic entity according to any one of claims 24 to 33, **characterized in that** the boss passes through the insulative layer and the terminal until it penetrates into the support.

35. Electronic entity according to any one of claims 24 to 34, **characterized in that** the boss is of gold or of gold alloy.

36. Electronic entity according to any one of claims 24 to 35, **characterized in that** the support includes at least two terminals and these terminals cover from 66% to 95% of the surface of the support that faces the electronic component.

37. Electronic entity according to claim 36, **characterized in that** the insulative layer, continuous or not, covers these terminals.

38. Electronic entity according to claim 37, **characterized in that** the insulative layer extends at least over the major portion of the surface of the support that faces the electronic component.

39. Electronic entity according to any one of claims 24 to 38, **characterized in that** the insulative layer covers at least the major portion of this antenna.

40. Electronic entity according to any one of claims 24 to 39, **characterized in that** this antenna terminal made of a conducting ink is obtained by screenprinting.

41. Electronic entity according to any one of claims 24 to 40, **characterized in that** the insulative layer is an insulative varnish.

42. Electronic entity according to claim 41, **characterized in that** this insulative varnish has a polymerization energy of less than 1000 mJ/cm².

43. Electronic entity according to claim 42, **characterized in that** the insulative varnish has a polymerization energy of the order of 500 mJ/cm².

44. Electronic entity according to any one of claims 24 to 40, **characterized in that** the insulative layer is made of a non-conducting ink or of a fibrous material.

45. Electronic entity according to any one of claims 24 to 44, **characterized in that** this insulative layer is deposited by screenprinting.

46. Electronic entity according to any one of claims 24 to 45, **characterized in that** the thickness of the insulative layer is from 5 to 25 microns, preferably from 10 to 15 microns.
